# EUROPEAN PATENT SPECIFICATION

(11) **EP 4 686 338 B1**
(45) Date of publication and mention of the grant of the patent: **18.11.2026**
(21) Application number: 24203375.1
(22) Date of filing: 27.09.2024
(51) Int. Cl.: H10B 61/00, H10N 50/01, H10N 50/10, H10N 50/80

(54) **LAYOUT PATTERN OF SEMICONDUCTOR STRUCTURE AND FORMING METHOD THEREOF**
LAYOUT-MUSTER EINER HALBLEITERSTRUKTUR UND HERSTELLUNGSVERFAHREN DAFÜR
MOTIF DE DISPOSITION DE STRUCTURE SEMI-CONDUCTRICE ET SON PROCÉDÉ DE FORMATION

(30) Priority: 23.07.2024 TW 113127432
(43) Date of publication of application: 28.01.2026
(73) Proprietor: United Microelectronics Corp., Hsin-Chu City 300 (TW)
(72) Inventor: HSU, Chia-Chang, 802 Kaohsiung City (TW); WANG, Hui-Lin, 108 Taipei City (TW)
(74) Representative: Isarpatent

(56) References cited:
- WO-A1-2022/116871
- US-A1- 2018 145 247
- US-A1- 2019 066 749
- US-A1- 2020 136 018
- US-A1- 2021 367 143

## Description

The invention relates to the field of semiconductor manufacturing, in particular to a layout pattern of a semiconductor structure with SOT-MTJ (magnetic tunneling junction using spin orbit torque technology) and a forming method thereof, which has the advantage of improving the uniformity of device pattern density.

It is known that the magnetoresistance (MR) effect is the effect that the resistance of a material changes with the change of an external magnetic field. Its physical quantity is defined as the difference in resistance with or without a magnetic field divided by the original resistance to represent the rate of resistance change. At present, magnetoresistance effect has been successfully applied to hard disk production, which has important commercial application value. In addition, magnetic random access memory (MRAM) can be made by using the characteristics that giant magnetoresistance substances have different resistance values in different magnetization states, which has the advantage that the stored data can be kept without power supply.

The magnetoresistance effect is also applied in the field of magnetic field sensor, for example, the electronic compass component of the global positioning system (GPS) in a mobile phone to provide information such as the user's moving direction. At present, there are various magnetic field sensing technologies in the market, such as anisotropic magneto resistance (AMR) sensor, giant magneto resistance (GMR) sensor, magnetic tunneling junction (MTJ) sensor and so on. However, the shortcomings of the above-mentioned prior art usually include: larger chip area, more expensive manufacturing process, more power consumption, insufficient sensitivity, and susceptibility to temperature changes, etc., and further improvement is necessary.

Spin-transfer torque (STT) is one of the techniques used to control the direction of magnetic moment in magnetic materials in the field of spintronics. The core principle of STT technology is to use spin-polarized current. When a spin-polarized current passes through a magnetic material, electrons in the current will transfer their spin angular momentum to the magnetic moment of the material, thus changing the direction of the magnetic moment. This technology has been successfully applied to the first generation MRAM, but its writing current is large, which limits its further development.

Layouts of the prior art are described in WO 2022 / 116871 A1, US 2018 / 0145247 A1, US 2020 0136018 A1, US 2021 / 0367143 A1 and US 2019 / 0066749 A1.

The invention provides a layout pattern of a semiconductor structure, which comprises a plurality of SOT(spin-orbit torque) layers arranged in an array and located on a dielectric layer, wherein two contact plug structures are connected below each SOT layer, a plurality of magnetic tunnel junction (MTJ) structures are arranged in an array, and each MTJ structure is located on each SOT layer, wherein each SOT layer comprises one MTJ structure disposed thereon, and a plurality of dummy MTJ structures located between the plurality of MTJ structures, wherein the shape of each dummy MTJ structure is different from the shape of each MTJ structure.

The invention also provides a method for forming a layout pattern of a semiconductor structure, which comprises the following steps: forming a plurality of SOT(spin-orbit torque) layers arranged in an array and located on a dielectric layer, wherein two contact plug structures are connected below each SOT layer, forming a plurality of magnetic tunnel junction (MTJ) structures arranged in an array, wherein each MTJ structure is located on each SOT layer, and each SOT layer comprises one MTJ structure disposed thereon, and forming a plurality of dummy MTJ structures between the dummy MTJ structures, wherein the shape of each dummy MTJ structure is different from the shape of each MTJ structure.

To sum up, the present invention provides a semiconductor structure and a manufacturing method thereof. The main feature is that under the SOT-MTJ structure, the configuration space of a single SOT-MTJ structure needs to contain the underlying SOT layer and two contact plug structures, resulting in a rectangular shape or elliptical shape SOT-MTJ structure. This will result in that when a plurality of SOT-MTJ structures are arranged on a plane, the SOT-MTJ structures in one direction (for example, the long axis direction of an elliptical shape) will be arranged loosely, and the SOT-MTJ structures in the other direction (for example, the short axis direction of an elliptical shape) will be arranged closely. Therefore, this will lead to the problem of uneven thickness in the etching step and affect the process quality. Based on the above problems, the dummy MTJ structures are added under the arrangement of SOT-MTJ structures, so that the spacing between adjacent SOT-MTJ structures can be reduced, the overall pattern density becomes more uniform, and the quality of the manufacturing process is improved. In addition, in an embodiment of the invention, the oval SOT layer, the rectangular shape MTJ structure and the square or circular dummy MTJ structure are arranged reasonably with the gap between elements, so that the uniformity of pattern density can be effectively improved, and the purpose of improving product quality can be achieved.

These and other objectives of the present invention will no doubt become obvious to those of ordinary skill in the art after reading the following detailed description of the preferred embodiment that is illustrated in the various figures and drawings.

In order to make the following easier to understand, readers can refer to the drawings and their detailed descriptions at the same time when reading the present invention. Through the specific embodiments in the present specification and referring to the corresponding drawings, the specific embodiments of the present invention will be explained in detail, and the working principle of the specific embodiments of the present invention will be expounded. In addition, for the sake of clarity, the features in the drawings may not be drawn to the actual scale, so the dimensions of some features in some drawings may be deliberately enlarged or reduced.
Fig. 1 shows a schematic diagram of a two-terminal MTJ(magnetic tunnel junction) structure based on STT technology and a three-terminal MTJ structure based on SOT technology.
Fig. 2 is a schematic diagram showing a layout pattern of a semiconductor structure according to a first embodiment of the present invention.
Fig. 3 is a schematic view of the sectional structure taken along the section line A-A' in Fig. 2.
Fig. 4 is a schematic diagram showing a layout pattern of a semiconductor structure according to a second embodiment of the present invention.
Fig. 5 is a top view of a semiconductor structure layout pattern according to a second embodiment of the present invention after etching the SOT layer.
Fig. 6 is a schematic view of the sectional structure taken along the section line B-B' and section line C-C' in Fig. 5.

To provide a better understanding of the present invention to users skilled in the technology of the present invention, preferred embodiments are detailed as follows. The preferred embodiments of the present invention are illustrated in the accompanying drawings with numbered elements to clarify the contents and the effects to be achieved.

Please note that the figures are only for illustration and the figures may not be to scale. The scale may be further modified according to different design considerations. When referring to the words "up" or "down" that describe the relationship between components in the text, it is well known in the art and should be clearly understood that these words refer to relative positions that can be inverted to obtain a similar structure, and these structures should therefore not be precluded from the scope of the claims in the present invention.

Although the present invention uses the terms first, second, third, etc. to describe elements, components, regions, layers, and/or sections, it should be understood that such elements, components, regions, layers, and/or sections should not be limited by such terms. These terms are only used to distinguish one element, component, region, layer and/or block from another element, component, region, layer and/or block. They do not imply or represent any previous ordinal number of the element, nor do they represent the arrangement order of one element and another element, or the order of manufacturing methods. Therefore, the first element, component, region, layer or block discussed below can also be referred to as the second element, component, region, layer or block without departing from the specific embodiments of the present invention.

The term "about" or "substantially" mentioned in the present invention usually means within 20% of a given value or range, such as within 10%, or within 5%, or within 3%, or within 2%, or within 1%, or within 0.5%. It should be noted that the quantity provided in the specification is approximate, that is, the meaning of "about" or "substantially" can still be implied without specifying "about" or "substantially".

The terms "coupling" and "electrical connection" mentioned in the present invention include any direct and indirect means of electrical connection. For example, if the first component is described as being coupled to the second component, it means that the first component can be directly electrically connected to the second component, or indirectly electrically connected to the second component through other devices or connecting means.

Although the invention of the present invention is described below by specific embodiments, the inventive principles of the present invention can also be applied to other embodiments. In addition, in order not to obscure the spirit of the present invention, specific details are omitted, and the omitted details are within the knowledge of those with ordinary knowledge in the technical field.

As mentioned above, the spin-transfer torque (STT) is one of the techniques used to control the direction of magnetic moment in magnetic materials in the field of spintronics. However, there are still some technical characteristics (such as large writing current) that limit its development.

Therefore, the industry is currently studying and developing another technology different from STT, that is, spin-orbit torque (SOT). SOT technology uses spin-orbit coupling effect (or spin Hall effect (SHE)). When the current passes through materials with strong spin-orbit coupling (such as heavy metals), pure spin current will be generated. This pure spin flow will not directly produce charge flow, but it can exert torque on the magnetic moments of adjacent magnetic layers to realize magnetic moment inversion.

The advantage of SOT technology lies in its low write current density and faster magnetic moment reversal. In addition, SOT can also control the direction of magnetic moment reversal by controlling the direction of current, which has higher flexibility. Therefore, SOT technology is considered as one of the key technologies of the next generation MRAM. However, SOT technology requires special materials and structural design, and the manufacturing process is relatively complicated. Compared with STT technology, SOT technology plays a key role in emerging technologies such as magnetic random access memory (MRAM), which is expected to bring faster and more energy-saving storage solutions.

In the following, the semiconductor structure of the present invention will be based on SOT technology, that is to say, the semiconductor structure of the present invention includes the basic architecture of SOT technology (including a SOT layer and two contact plug structures, which will be explained in the following paragraphs).

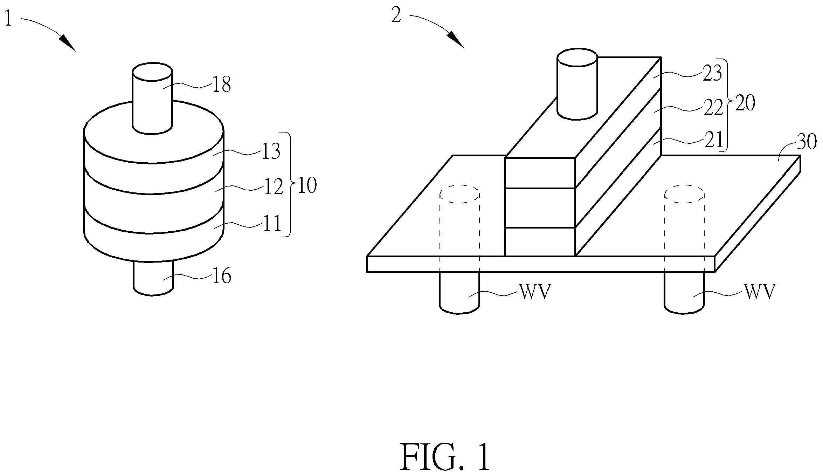

Fig. 1 shows a schematic diagram of a two-terminal MTJ(magnetic tunnel junction) structure based on STT technology and a three-terminal MTJ structure based on SOT technology. As shown in Fig. 1, the left half shows a two-terminal MTJ structure 1 (namely, an MTJ structure based on STT technology, hereinafter referred to as STT-MTJ structure), which includes an MTJ structure 10, and contact plug structures 16 and 18 are respectively connected at the upper and lower ends. The MTJ structure 10 includes a multilayer structure, for example, it may include a stack of multilayer materials such as a free layer 11, a barrier layer 12 and a pinned layer 13. It is worth noting that in the STT-MTJ structure 1, the current flows from the contact plug structure 16 to the contact plug structure 18, or vice versa. That is to say, the current direction is perpendicular to the MTJ structure 10, wherein the current perpendicular to the MTJ structure 10 will generate a spin transfer torque, which can reverse the magnetic moment direction of the magnetic layer.

On the other hand, on the right side of Figure 1, a three-terminal MTJ structure 2 based on SOT technology (that is, an MTJ structure based on SOT technology, hereinafter referred to as SOT-MTJ structure) is drawn, which includes an MTJ structure 20, a contact plug structure V2 connected at the upper end, a SOT layer 30 connected below the SOT layer 30 and two contact plug structures WV. The MTJ structure 20 includes a multilayer structure, for example, it may include a stack of multilayer materials such as a free layer 21, a barrier layer 22 and a fixed layer 23. Notably, compared with the STT-MTJ structure 1, there are more SOT layers 30 in the SOT-MTJ structure 2, and two contact plug structures WV are included below the SOT layers 30. In the SOT-MTJ structure 2, the current flows from one contact plug structure WV to another contact plug structure WV. That is to say, the current direction is parallel to the MTJ structure 20, wherein the current parallel to the MTJ structure 20 will generate a spin-orbit torque, which can reverse the magnetic moment direction of the magnetic layer.

In addition, although this embodiment only shows that the MTJ structure includes a free layer 21, a barrier layer 22 and a fixed layer 23, the actual MTJ structure may include more layers of materials, such as a cap layer, an upper electrode, a lower electrode and the like, and these material layers are not shown here for the sake of simplicity. As for the materials of the above-mentioned material layers, they will be described in the following paragraphs.

As can be seen from the description in the above paragraphs, the SOT-MTJ structure 2 needs to form SOT layer 30 and two lower contact plug structures WV to connect SOT layers, so a single SOT-MTJ structure 2 will occupy more area than a single STT-MTJ structure 1. Since the structure of the present invention is based on SOT technology, the following paragraphs will focus on describing the related characteristics of the SOT-MTJ structure of the present invention.

To form the SOT-MTJ structure as shown in Figure 1, in the actual process, two contact plug structures WV can be formed in a dielectric layer (not shown), and then a SOT material layer (that is, an unetched SOT material layer, not shown here) is formed, and then a patterned MTJ structure 20 is formed on the SOT material layer, and then the SOT material layer is patterned and divided into a plurality of SOT layer 30 by a photolithography etching step.

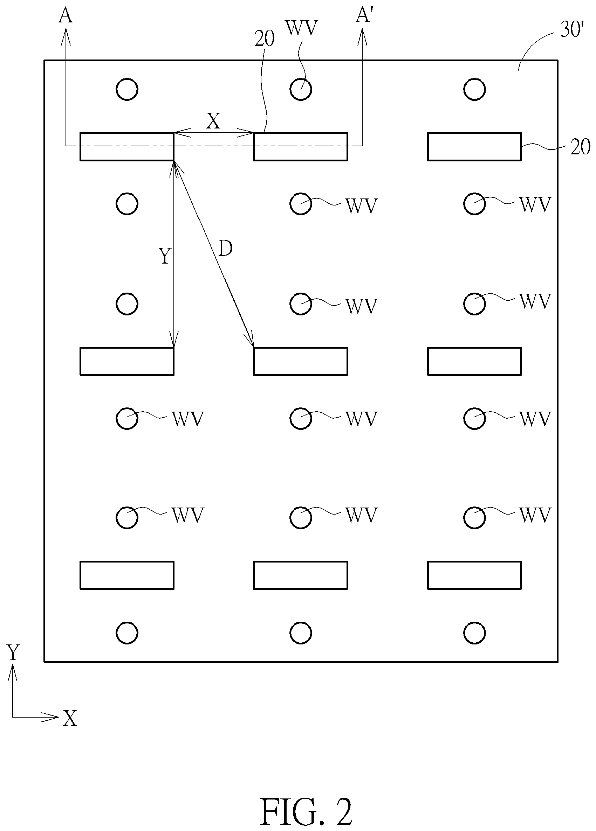

In more detail, Fig. 2 shows a schematic diagram of a layout pattern of a semiconductor structure according to a first embodiment of the present invention. The semiconductor structure described here includes the above SOT-MTJ structure. In Fig. 2, a contact plug structure WV is shown, which includes a SOT material layer 30' and a plurality of MTJ structures 20. The SOT material layer 30' described here will be divided into a plurality of SOT layers 30 separated from each other in the next step. That is, in the top view shown in Fig. 2, the SOT material layer 30' is about to undergo an exposure lithography and etching process to divide the SOT material layer 30' into a plurality of SOT layers 30.

As shown in Fig. 2, in the arrangement of the MTJ structures 20, considering the arrangement mode of the most efficient use of space, the distance X between adjacent MTJ structures in the lateral direction (the X-axis direction) can be set as the minimum distance of the current process, that is to say, if the distance between two adjacent MTJ structures in the lateral direction is less than X, it may lead to the failure to separate the two adjacent MTJ structures from each other after exposure, resulting in electrical defects. Take the 22 nm process as an example, the distance X is about 152 nm, but it is not limited to this. However, as mentioned above, since each SOT-MTJ structure needs to include two contact plug structures WV, adjacent MTJ structures 20 in the longitudinal direction (the Y-axis direction) need to consider not only the minimum distance in the process, but also the arrangement space of the contact plug structures WV. Therefore, as shown in Fig. 2, the distance Y between two adjacent MTJ structures 20 in the Y direction is usually significantly greater than the distance X in the X direction. For example, the distance Y is about 350 nm at 22 nm. In addition, the distance D between the two MTJ structures 20 arranged at the diagonal ends is about 381 nm, which means that the distance D is also significantly greater than the distance X.

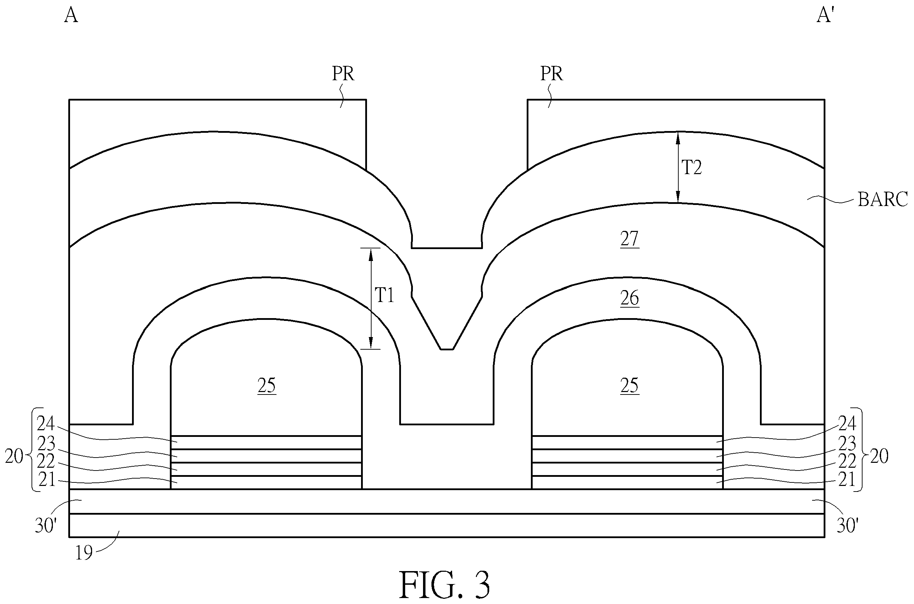

Reference can be made to Fig. 3, which shows a schematic diagram of the cross-sectional structure taken along the section line A-A' in Fig. 2. As shown in Fig. 3, after the contact plug structures (contact plug structures WV in Fig. 2) are completed, the lower electrode layer 19 is formed to electrically connect the contact plug structure, then a SOT material layer 30' is formed, and then the MTJ structure 20 is continuously formed above the SOT material layer 30', wherein the MTJ structure includes a free layer 21, a barrier layer 22 and a fixed layer 23. In addition, the MTJ structure 20 further includes a barrier layer 24 and an upper electrode layer 25. In which the free layer 21, the barrier layer 22, the fixed layer 23, the barrier layer 24 and the upper electrode layer 25 have all been patterned and located on the SOT material layer 30'. Then, a dielectric layer 26, an oxide layer 27, a bottom antireflection layer BARC and a patterned photoresist layer PR are sequentially formed.

The material of the lower electrode layer 19 is, for example, tantalum nitride, and the lower electrode layer 19 is located between the SOT material layer 30' and the contact plug structures WV, which can provide better interface quality and current quality and improve electrical properties. However, in some embodiments of the present invention, the lower electrode layer 19 may be omitted and the contact plug structures WV can be directly contacted with the SOT material layer 30', and the above embodiment is also within the scope of the present invention.

The SOT material layer 30' is usually a heavy metal such as tungsten (W), platinum (Pt) or tantalum (Ta). These materials have strong spin-orbit coupling effect and can effectively convert current into spin-orbit torque. In this embodiment, taking tungsten as an example, the thickness is about 30 angstroms, but the invention is not limited to this. It is worth noting that the SOT material layer 30' in the present invention is made of different materials from the lower electrode layer 19, and the SOT material layer 30' and the lower electrode layer 19 belong to two different elements. Furthermore, the lower electrode layer 19 serves as an electrode to provide current, while the SOT material layer 30' serves as a current channel of the SOT-MTJ structure, so the SOT material layer 30' cannot be used as the lower electrode layer. If the lower electrode layer 19 is omitted in some embodiments, the contact plug structures WV are used as the lower electrode layer.

The free layer 21 can be made of ferromagnetic material, and the free layer 21 is responsible for storing the "0" and "1" states of data. The magnetization direction of the free layer 21 can be changed by applying an external magnetic field or spin polarization current. When the magnetization direction of the free layer 21 is parallel to the fixed layer 23, the resistance of the MTJ structure 20 is low, representing data "0". When the magnetization direction of the free layer 21 is antiparallel to the fixed layer 23, the resistance of the MTJ is high, representing data "1". The free layer usually uses a soft magnetic material with easy magnetization. The magnetization of these materials is easily influenced by external magnetic field or current, which makes it easy to write and read data. Commonly used soft magnetic materials include iron, cobalt, nickel, CoFeB (cobalt iron boron) alloy, NiFe (nickel iron) alloy and FePt (iron platinum) alloy, but the present invention is not limited to this. :

The barrier layer 22 can be made of an insulating material containing oxide, and functions to separate the free layer 21 and the fixed layer 23, and prevent electrons from flowing directly from the free layer 21 to the fixed layer 23. However, due to the quantum tunneling effect, electrons may have a certain probability to penetrate the barrier layer 22 and tunnel from the free layer 21 to the fixed layer 23. The thickness and material of the barrier layer 22 have great influence on the magnetoresistance effect of the MTJ. The thinner the barrier layer 22, the greater the tunneling current and the stronger the magnetoresistance effect. Commonly used barrier layer 22 materials include MgO (magnesium oxide) or Al₂O₃ (aluminium oxide), but are not limited to this.

The fixed layer 23 may contain ferromagnetic material, and the magnetization direction of the fixed layer 23 is fixed, providing a reference magnetic field for the free layer 21. The magnetization direction of the fixed layer 23 is generally opposite to the initial magnetization direction of the free layer 21, so as to achieve maximum magnetoresistance change. The fixed layer 23 usually uses a hard magnetic material that is difficult to magnetize. For example, CoPt (cobalt platinum) alloy, CoFe (cobalt iron) alloy, FePt (iron platinum) alloy, IrMn (iridium manganese) alloy, PtMn (platinum manganese) alloy, Co/Pt or Co/Pd multilayer film, etc., but not limited thereto. The magnetization of these materials is not easily influenced by external magnetic field or current, which ensures the stability of the magnetization direction of the fixed layer 23.

The main function of the barrier layer 24 is to protect the MTJ structure 20 from external environment, such as oxidation, corrosion and mechanical damage. It can also be used as a barrier layer to prevent other materials from diffusing into the MTJ structure 20 and affecting its performance. The barrier layer 24 is usually made of materials with good chemical stability and mechanical strength, such as Ru (ruthenium), Ta (tantalum), Ti (titanium), Cu (copper), Al₂O₃ (aluminium oxide), TaN (tantalum nitride), etc., but not limited thereto.

The thicknesses of the SOT material layer 30', the MTJ structure 20 and the barrier layer 24 can be adjusted according to actual needs. In this embodiment, the total thickness of the lower electrode layer 19, the SOT material layer 30', the MTJ structure 20 and the barrier layer 24 is about 250 angstroms, but the present invention is not limited to this.

The upper electrode layer 25 is used to connect the subsequent contact plug structure with the MTJ structure 20. The width and area of the upper electrode layer 25 may be the same as that of the MTJ structure 20, and the material of the upper electrode layer 25 is, for example, TiN (titanium nitride), but not limited thereto. In this embodiment, the thickness of the upper electrode layer 25 is about 400 angstroms, but it is not limited to this.

The dielectric layer 26 covers the patterned MTJ structure 20, the barrier layer 24 and the upper electrode layer 25. The material of the dielectric layer 26 is, for example, silicon nitride (SiN). The dielectric layer 26 has the functions of providing electrical insulation, preventing leakage, preventing impurity diffusion, adjusting film stress, avoiding structural deformation or rupture caused by excessive stress, and serving as a protective layer in the etching process to ensure the etching accuracy of the underlying layer. The thickness of the dielectric layer 26 in this embodiment is about 250 angstroms, but it is not limited to this.

The material of the oxide layer 27 is, for example, silicon oxide, which is usually composed of an ultra-low-k (ULK) oxide layer to reduce the capacitance effect and function as an interlayer dielectric layer. The thickness of the oxide layer 27 in this embodiment is about 400 angstroms, but it is not limited to this.

The function of the bottom anti-reflection layer BARC is to reduce the reflection of light on the oxide layer 27 during lithography and improve the lithography resolution. A patterned photoresist layer PR is formed on the bottom antireflection layer BARC.

The applicant found that in the process of etching with the patterned photoresist layer PR as a mask, there may be a problem that affects the quality of the process, that is, the uneven thickness of the bottom antireflection layer BARC at different positions. The reason for the above problems is that after the formation of oxide layers 27, a groove will be generated between adjacent oxide layers 27, and the depth of the groove is related to the distance between MTJ structures 20. More specifically, the depth of the groove between oxide layers 27 will change with the distance between adjacent MTJ structures 20. If the distance between adjacent MTJ structures is wider, the depth of the groove will be shallower, whereas if the distance between adjacent MTJ structures is shorter, the depth of the groove will be deeper.

Taking Figure 3 as an example, it can be found from Figure 3 that because two adjacent MTJ structures are arranged closely in the X direction, after the dielectric layer 26 and the oxide layer 27 are completed, a deep groove will be formed between the oxide layer 27, and then the bottom anti-reflection layer BARC will be filled in this groove, so that the thickness of the bottom anti-reflection layer BARC there is different from that of other parts. For example, the thickness T1 of the bottom antireflection layer BARC filled in the groove between adjacent oxide layers 27 is about 1500 angstroms, while the thickness T2 of the bottom antireflection layer BARC in other parts (that is, the bottom antireflection layer BARC not filled in the groove between the oxide layers 27) is about 900 to 1000 angstroms. On the other hand, referring to Fig. 2 together, due to the long distance between adjacent MTJ structures 20 in the Y direction, the depth of the groove between oxide layers 27 is shallow, resulting in the shallow thickness of the bottom anti-reflection layer BARC. In this way, it is difficult to control the etching parameters because of the uneven thickness of the bottom anti-reflection layer BARC at different positions, and it is easy to cause problems in the etching process, such as the failure to completely cut off the underlying SOT material layer 30' by etching, or the damage to other components below by over-etching.

In the following, different embodiments of the semiconductor structure and its manufacturing method of the present invention will be described, and in order to simplify the description, the following description will mainly focus on the differences of each embodiment, and will not repeat the similarities. In addition, the same elements in various embodiments of the present invention are labeled with the same reference numerals, so as to facilitate the comparison among various embodiments.

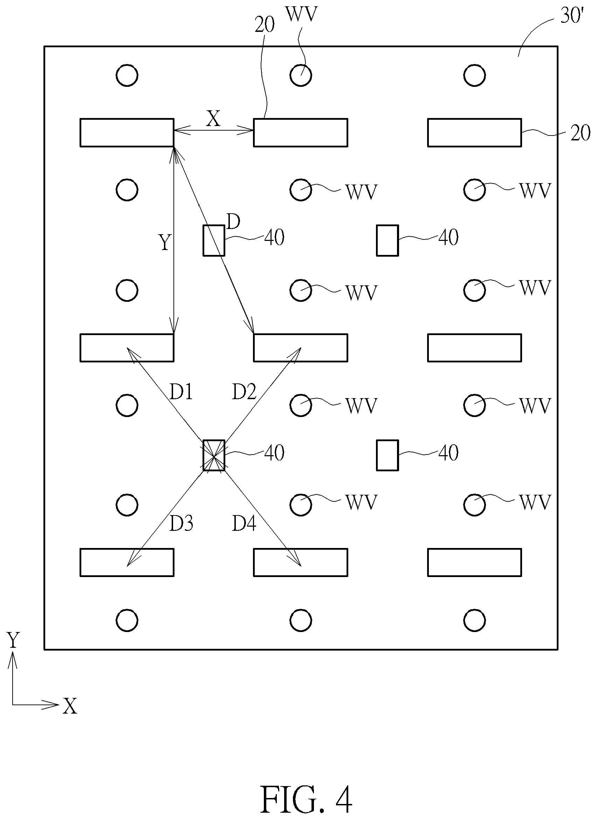

In order to avoid the etching problem caused by the uneven thickness of the top and bottom anti-reflective layers BARC, in another embodiment of the present invention, an improved layout pattern of a semiconductor structure is provided. Please refer to Fig. 4, which shows a schematic diagram of a layout pattern of a semiconductor structure according to a second embodiment of the present invention. As shown in Fig. 4, most of the components are the same as those in the first embodiment, so they are not repeated here. Notably, this embodiment further includes a dummy MTJ structure 40 located between four adjacent MTJ structures 20. It is worth noting that the adjacent MTJ structures in the X direction have been arranged at the minimum pitch as mentioned above, but the adjacent MTJ structures in the Y direction are not arranged at the minimum pitch because the space of the contact plug structures WV below needs to be considered. This results in that there is still room to accommodate the dummy MTJ structure 40 in the Y direction. In this embodiment, the dummy MTJ structure 40 is arranged between four adjacent MTJ structures 20, wherein the distances from the dummy MTJ structure 40 to the four adjacent MTJ structures 20 are equal. That is to say, if the four adjacent MTJ structures 20 are connected to each other into a rectangular shape, the dummy MTJ structure 40 will be located at the center of this rectangular shape. As shown in Fig. 4, if the center point of the dummy MTJ structure 40 and the center points of four adjacent MTJ structures 20 are respectively measured as distances D1, D2, D3 and D4, the distances D1, D2, D3 and D4 are preferably the same as each other.

After the dummy MTJ structure 40 is added, the dielectric layer 26, the oxide layer 27, the bottom antireflection layer BARC and the patterned photoresist layer PR are sequentially formed in the following steps. After the dielectric layer 26 and the oxide layer 27 are formed, it is found that the groove depths between the oxide layers 27 on adjacent MTJ structures 20 in all directions (the X direction, the Y direction and the diagonal direction) are more consistent, because the dummy MTJ structures 40 exist in the center of the rectangular shape where every four MTJ structures 20 are arranged, that is, the center of the diagonal (that is, the midpoint of the diagonal of the rectangular shape). Because the diagonal center position is closer to the center position of the MTJ structure 20 in the Y direction (that is, the midpoint of the long side of the rectangular shape), it will also affect the groove depth of the oxide layer 27 in the Y direction, further deepen the groove depth between the oxide layers 27 in the Y direction and diagonal direction, and make the thickness of the bottom anti-reflection layer BARC filled in the groove close to the same. This can improve the stability and quality of the process.

In addition, it is worth noting that, from the top view, the MTJ structure 20 of the present invention is rectangular shape, which is to match the current direction of the SOT layer. By designing the MTJ structure 20 into a rectangular shape, the two poles of the MTJ structure can be located at the two ends of the rectangular shape structure respectively, and the current direction and the magnetic moment direction are parallel to each other. However, the function of the dummy MTJ structure 40 is to reduce the pattern density difference and make the distance between the MTJ structure 20 in different directions and adjacent patterns (including another MTJ structure 20 or dummy MTJ structure 40) approach the same, so the shape of the dummy MTJ structure 40 of the present invention may be different from that of the MTJ structure 20. The shape of the dummy MTJ structure 40 in this embodiment is, for example, a circle, a square, a rectangular shape, etc., but the present invention is not limited to this. Preferably, from the top view, the area of the dummy MTJ structure 40 is smaller than that of the MTJ structure 20, so as not to influence the exposure and development process due to the excessively large area of the dummy MTJ structure.

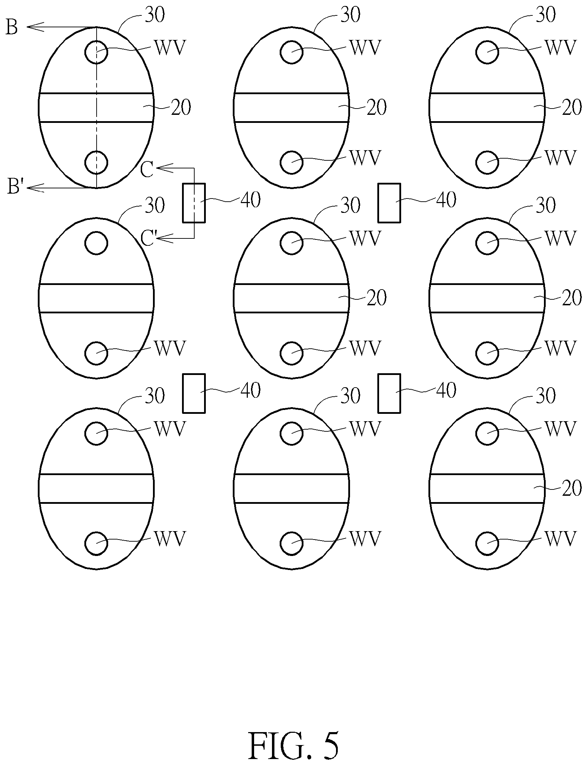

Next, please refer to Fig. 5, which shows a schematic diagram of the layout pattern of the semiconductor structure according to the second embodiment of the present invention after etching the SOT layer. Using the patterned photoresist layer PR as a mask, an etching step is performed to remove part of the bottom antireflection layer BARC, part of the oxide layer 27, part of the dielectric layer 26 and part of the SOT material layer 30' below, so as to cut the SOT material layer 30' into a plurality of SOT layers 30 separated from each other. It is worth noting that the SOT layer 30 in Fig. 5 presents an oval-like shape (or elliptical shape) because the corners of the pattern will be rounding after etching. The connecting line direction of the two contact plug structures WV is parallel to the long axis of the elliptical shape (that is, the Y direction), while the long side of the rectangular shape MTJ structure is parallel to the short axis of the elliptical shape (that is, the X direction).

In this embodiment, the two contact plug structures WV are located below the SOT layer 30, and the SOT layer 30 presents an elliptical shape, the MTJ structure 20 is located on the SOT layer 30 and is rectangular shape, and the dummy MTJ structure 40 is located on the SOT layer 30 and presents a circle, a square or a rectangular shape. If the dummy MTJ structure 40 is rectangular shape, its long axis direction can be perpendicular to the long axis direction of the MTJ structure. For example, as shown in Figure 4, if the long axis direction of the MTJ structure 20 extends along the X axis direction and if the dummy MTJ structure 40 is rectangular shape, the long axis direction of the dummy MTJ structure 40 can extend along the Y axis direction. In this way, it is easier to design the position of the dummy MTJ40 to avoid the position of the SOT layer 30, and avoid the electrical error caused by the contact of the dummy MTJ structure 40 with the SOT layer 30. In a word, by arranging the elements in the invention, the gaps between the elements can be effectively utilized, and the arrangement of the elements can effectively improve the uniformity of pattern density.

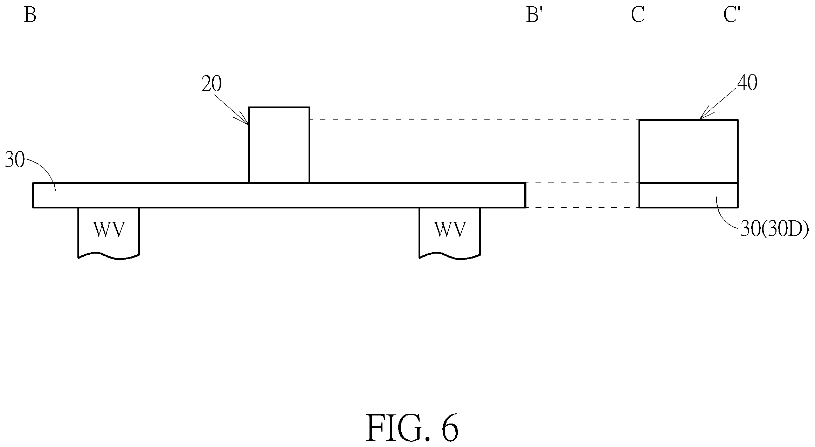

In addition, reference can be made to Fig. 6, which is a schematic view of the cross-sectional structure taken along section line B-B' and section line C-C' in Fig. 5. As shown in Fig. 6, it is shown that the MTJ structure 20 is located on the SOT layer 30 and the dummy MTJ structure 40 is located on the SOT layer 30. In Fig. 6, some material layers are not drawn for simplicity. The detailed material layer stack of the MTJ structure 20 and the dummy MTJ structure 40 here can refer to Figure 3, for example, including the free layer, the barrier layer, the fixed layer, the barrier layer, an upper electrode layer, and the like.

It is worth noting that, from the sectional view, there are two contact plug structures WV under the SOT layer on the left side of Figure 6, which means that the MTJ structure 20 will be electrically connected with other elements. On the other hand, the SOT layer 30 is also included under the dummy MTJ structure 40 on the right in Fig. 6, but the contact plug structure is not included under the MTJ structure 40, which means that the dummy MTJ structure 40 will not be electrically connected with other elements by the contact plug structure.

Another noteworthy thing is that the width of the SOT layer 30 on the left side of Figure 6 is larger than that of the MTJ structure 20, that is to say, in the etching process, the SOT material layer 30' is patterned to form a plurality of SOT layers 30 by using the photoresist layer PR as a mask, and the range of the SOT layers 30 needs to include two contact plug structures WV and the MTJ structure 20. As for the bottom of the dummy MTJ structure 40, the SOT layer 30 is also included, but during the etching process, the dummy MTJ structure 40 is not covered by the photoresist layer PR, so both the dummy MTJ structure 40 and the underlying SOT layer 30 will be etched together with the lithography etching process. In which the dummy MTJ structure 40 serves as a mask for the SOT layer 30, the width of the dummy MTJ structure 40 and the width of the SOT layer 30 are preferably equal to each other after the etching step is completed. Here, for convenience of distinction, the SOT layer 30 under the dummy MTJ structure 40 is defined as the dummy SOT layer 30D.

As mentioned above, during the etching process, the MTJ structure 20 is protected by the upper photoresist layer PR as a mask, so after the etching step is completed, the MTJ structure 20 still maintains its original structure and its thickness will not change. However, in the same etching process, the dummy MTJ structure 40 is not covered by the photoresist layer PR, so the dummy MTJ structure 40 may be etched at the same time in the etching process, resulting in a decrease in the thickness of the dummy MTJ structure. From Fig. 6, the height of the dummy MTJ structure may be smaller than that of the MTJ structure 20. This variation is also within the scope of the present invention.

Based on the above description and drawings, the present invention provides a layout pattern of a semiconductor structure. Please refer to the embodiment shown in Figures 4-6, which includes a plurality of SOT(spin-orbit torque) layers 30 arranged in an array and located on a dielectric layer (i.e., the dielectric layer for accommodating the contact plug structure WV, not shown), wherein two contact plug structures WV are connected below each SOT layer 30. A plurality of magnetic tunnel junction (MTJ) structures 20 are arranged in an array, and each MTJ structure 20 is located on each SOT layer 30, wherein each SOT layer 30 contains one MTJ structure 20 or a plurality of dummy MTJ structures 40 disposed thereon, and the shape of each dummy MTJ structure 40 is different from the shape of each MTJ structure 20.

In some embodiments of the present invention, each MTJ structure 20 is arranged in a plurality of columns along a Y-axis direction, and a plurality of dummy MTJ structures 40 are located in gaps between columns of MTJ structures 20 (please refer to Figure 4, where dummy MTJ structures 40 are located between columns of a plurality of MTJ structures 20 arranged along the Y-axis direction).

In some embodiments of the present invention, each dummy MTJ structure 40 is located between four adjacent MTJ structures 20, and the distances between the dummy MTJ structures 40 and the four adjacent MTJ structures 20 are equal.

In some embodiments of the present invention, each MTJ structure 20 presents a rectangular shape when viewed from a top view, and a long side of the rectangular shape is parallel to an X-axis direction, wherein the X-axis direction and the Y-axis direction are perpendicular to each other.

In some embodiments of the present invention, each SOT layer 30 presents an elliptical shape when viewed from a top view.

In some embodiments of the present invention, each SOT layer 30 includes two contact plug structures WV arranged along the long axis of the elliptical shape.

In some embodiments of the present invention, each dummy MTJ structure 40 is circular or square when viewed from a top view.

In some embodiments of the present invention, a dummy SOT layer 30D is connected under each dummy MTJ structure 40, but no contact plug is connected below each dummy SOT layer 30D.

In some embodiments of the present invention, a height of the dummy MTJ structure 40 is smaller than a height of each MTJ structure 20 when viewed from a cross-sectional view (as shown in Fig. 6).

The present invention also provides a method for forming a layout pattern of a semiconductor structure, which comprises forming a plurality of SOT(spin-orbit torque) layers 30 arranged in an array and located on a dielectric layer, wherein two contact plug structures WV are connected under each SOT layer 30 to form a plurality of MTJ(magnetic tunnel junction) structures 20 arranged in an array, and each MTJ structure 20 is located on each SOT layer 30, wherein each SOT layer 30 contains one MTJ structure 20 disposed thereon, and a plurality of dummy MTJ structures 40 are formed between the plurality of MTJ structures 40, wherein the shape of each dummy MTJ structure 40 is different from that of each MTJ structure 20.

In some embodiments of the present invention, each MTJ structure 20 is arranged in a plurality of columns along a Y-axis direction, and a plurality of dummy MTJ structures 40 are located in gaps between columns of MTJ structures 20 (please refer to Figure 4, where dummy MTJ structures 40 are located between columns of a plurality of MTJ structures 20 arranged along the Y-axis direction).

In some embodiments of the present invention, each dummy MTJ structure 40 is located between four adjacent MTJ structures 20, and the distances between the dummy MTJ structures 40 and the four adjacent MTJ structures 20 are equal.

In some embodiments of the present invention, each MTJ structure 20 presents a rectangular shape when viewed from a top view, and a long side of the rectangular shape is parallel to an X-axis direction, wherein the X-axis direction and the Y-axis direction are perpendicular to each other.

In some embodiments of the present invention, each SOT layer 30 presents an elliptical shape when viewed from a top view.

In some embodiments of the present invention, each SOT layer 30 includes two contact plug structures WV arranged along the long axis of the elliptical shape.

In some embodiments of the present invention, each dummy MTJ structure 40 is circular or square when viewed from a top view.

In some embodiments of the present invention, a dummy SOT layer 30Dis connected under each dummy MTJ structure 40, but no contact plug is connected below each dummy SOT layer 30D.

In some embodiments of the present invention, a height of the dummy MTJ structure 40 is smaller than a height of each MTJ structure 20 when viewed from a cross-sectional view (as shown in Fig. 6).

In some embodiments of the present invention, it further includes forming a SOT material layer 30' under a plurality of MTJ structures 20 and a plurality of dummy MTJ structures 40, stacking a multilayer photoresist layer (including the dielectric layer 26, the oxide layer 27, the bottom antireflection layer BARC and the photoresist layer PR in Figure 3) on the SOT material layer 30', the plurality of MTJ structures 20 and the plurality of dummy MTJ structures 40, and performing an etching step to etch part of the multilayer photoresist layer and part of the SOT material layer 30' to divide the SOT material layer 30' into a plurality of SOT layers 30.

In some embodiments of the present invention, a lower electrode layer 19 is further formed, wherein a SOT layer 30 is located between the lower electrode layer 19 and the MTJ structure 20, and the lower electrode layer 19 and the SOT layer 30 contain different materials.

To sum up, the present invention provides a semiconductor structure and a manufacturing method thereof. The main feature is that under the SOT-MTJ structure, the configuration space of a single SOT-MTJ structure needs to contain the underlying SOT layer and two contact plug structures, resulting in a rectangular shape or elliptical shape SOT-MTJ structure. This will result in that when a plurality of SOT-MTJ structures are arranged on a plane, the SOT-MTJ structures in one direction (for example, the long axis direction of an elliptical shape) will be arranged loosely, and the SOT-MTJ structures in the other direction (for example, the short axis direction of an elliptical shape) will be arranged closely. Therefore, this will lead to the problem of uneven thickness in the etching step and affect the process quality. Based on the above problems, the dummy MTJ structures are added under the arrangement of SOT-MTJ structures, so that the spacing between adjacent SOT-MTJ structures can be reduced, the overall pattern density becomes more uniform, and the quality of the manufacturing process is improved. In addition, in an embodiment of the invention, the oval SOT layer, the rectangular shape MTJ structure and the square or circular dummy MTJ structure are arranged reasonably with the gap between elements, so that the uniformity of pattern density can be effectively improved, and the purpose of improving product quality can be achieved.

Those skilled in the art will readily observe that numerous modifications and alterations of the device and method may be made within the invention as defined by the claims.

## Claims

1. Layout pattern of a semiconductor structure, comprising:
a plurality of spin-orbit torque, SOT, layers (30) arranged in an array and located on a dielectric layer (26), wherein two contact plug structures (16; 18) are connected below each SOT layer (30);
a plurality of magnetic tunnel junction, MTJ, structures (20) are arranged in an array, and each MTJ structure (20) is located on each SOT layer (30), wherein each SOT layer (30) comprises one MTJ structure (20) disposed thereon;
**characterised by**
a plurality of dummy MTJ structures (40) located between the plurality of MTJ structures (20), wherein the shape of each dummy MTJ structure (40) is different from the shape of each MTJ structure (20).

2. Layout pattern of the semiconductor structure according to claim 1, wherein each of the MTJ structures (20) is arranged in a plurality of columns along a Y-axis direction, and the dummy MTJ structures (40) are located in the gaps between the columns composed of the MTJ structures (20) in particular wherein each dummy MTJ structure (40) is located between four adjacent MTJ structures (20), and the distances from the dummy MTJ structure (40) to the four adjacent MTJ structures (20) are equal and/or each of the MTJ structures (20) is rectangular shape when viewed from a top view, and a long side of the rectangular shape is parallel to an X-axis direction, wherein the X-axis direction and the Y-axis direction are perpendicular to each other.

3. Layout pattern of the semiconductor structure according to any one of claims 1 or 2, wherein each SOT layer (30) presents an elliptical shape when viewed from a top view, and in particular wherein the two contact plug structures (16; 18) included in each SOT layer (30) are arranged along a long axis of the elliptical shape.

4. Layout pattern of the semiconductor structure according to any one of claims 1 to 3, wherein each of the dummy MTJ structures (40) is circular shape or square shape when viewed from a top view.

5. Layout pattern of the semiconductor structure according to any one of claims 1 to 4, wherein a dummy SOT layer (30D) is connected below each dummy MTJ structure (40), but the contact plug structure (16; 18) is not connected below each dummy SOT layer (30D).

6. Layout pattern of the semiconductor structure according to any one of claims 1 to 5, wherein a height of the dummy MTJ structure (40) is smaller than a height of each MTJ structure (20) when viewed from a cross section.

7. Method for forming a layout pattern of a semiconductor structure, comprising:
forming a plurality of spin-orbit torque, SOT, layers arranged in an array and located on a dielectric layer (26), wherein two contact plug structures (16; 18) are connected below each SOT layer (30);
forming a plurality of magnetic tunnel junction, MTJ, structures arranged in an array, wherein each MTJ structure (20) is located on each SOT layer (30), and each SOT layer (30) comprises one MTJ structure (20) disposed thereon;
**characterised by**
forming a plurality of dummy MTJ structures (40) between the dummy MTJ structures (40), wherein the shape of each dummy MTJ structure (40) is different from the shape of each MTJ structure (20).

8. Method for forming a layout pattern of a semiconductor structure according to claim 7, wherein each of the MTJ structures (20) is arranged in a plurality of columns along a Y-axis direction, and the plurality of dummy MTJ structures (40) are located in gaps between the columns composed of the MTJ structures (20), in particular wherein each dummy MTJ structure (40) is located between four adjacent MTJ structures (20), and the distances from the dummy MTJ structure (40) to the four adjacent MTJ structures (20) are equal and/or each of the MTJ structures (20) is rectangular shape when viewed from a top view, and a long side of the rectangular shape is parallel to an X-axis direction, wherein the X-axis direction and the Y-axis direction are perpendicular to each other.r.

9. Method for forming a layout pattern of a semiconductor structure according to any one of claims 7 or 8, wherein each SOT layer (30) presents an elliptical shape when viewed from a top view, in particular wherein the two contact plug structures (16; 18) included in each SOT layer (30) are arranged along a long axis of the elliptical shape.

10. Method for forming a layout pattern of a semiconductor structure according to any one of claims 7 to 9, wherein each of the dummy MTJ structures (40) is circular shape or square shape when viewed from a top view.

11. Method for forming a layout pattern of a semiconductor structure according to any one of claims 7 to 10, wherein a dummy SOT layer (30D) is connected below each dummy MTJ structure (40), but the contact plug structure (16; 18) is not connected below each dummy SOT layer (30D).

12. Method for forming a layout pattern of a semiconductor structure according to any one of claims 7 to 11, wherein a height of the dummy MTJ structure (40) is smaller than a height of each of the MTJ structures (20) when viewed from a sectional view.

13. Method for forming a layout pattern of a semiconductor structure according to any one of claims 7 to 12, further comprising:
forming a SOT material layer under the plurality of MTJ structures (20) and the plurality of dummy MTJ structures (40);
stacking a multi-layer photoresist layer on the SOT material layer, the plurality of MTJ structures (20) and the plurality of dummy MTJ structures (40);
performing an etching step to etch part of the multilayer photoresist layer and part of the SOT material layer to divide the SOT material layer into the plurality of SOT layers (30).

14. Method for forming a layout pattern of a semiconductor structure according to any one of claims 7 to 13, further comprising forming a lower electrode layer (19), wherein the SOT layer (30) is located between the lower electrode layer and the MTJ structure (20), and the lower electrode layer and the SOT layer (30) contain different materials.

## Patentansprüche

1. Layout-Muster einer Halbleiterstruktur, umfassend:
mehrere Spin-Orbit-Torque (SOT)-Schichten (30), die in einem Array angeordnet sind und sich auf einer dielektrischen Schicht (26) befinden, wobei zwei Kontaktsteckerstrukturen (16; 18) unter jeder SOT-Schicht (30) verbunden sind;
mehrere Magnettunnelübergangs (MTJ)-Strukturen (20) in einem Array angeordnet sind, und
jede MTJ-Struktur (20) sich auf jeder SOT-Schicht (30) befindet, wobei jede SOT-Schicht (30) eine darauf angeordnete MTJ-Struktur (20) umfasst;
**gekennzeichnet durch**
mehrere Dummy-MTJ-Strukturen (40), die sich zwischen den mehreren MTJ-Strukturen (20) befinden, wobei sich die Form jeder Dummy-MTJ-Struktur (40) von der Form jeder MTJ-Struktur (20) unterscheidet.

2. Layout-Muster der Halbleiterstruktur nach Anspruch 1, wobei jede der MTJ-Strukturen (20) in mehreren Spalten entlang einer Y-Achsen-Richtung angeordnet ist und die Dummy-MTJ-Strukturen (40) sich in den Lücken zwischen den aus den MTJ-Strukturen (20) bestehenden Spalten befinden, wobei insbesondere jede Dummy-MTJ-Struktur (40) sich zwischen vier benachbarten MTJ-Strukturen (20) befindet und die Distanzen von der Dummy-MTJ-Struktur (40) zu den vier benachbarten MTJ-Strukturen (20) gleich sind und/oder jede der MTJ-Strukturen (20), in einer Draufsicht betrachtet, eine rechteckige Form hat und eine Längsseite der rechteckigen Form parallel zu einer X-Achsen-Richtung verläuft, wobei die X-Achsen-Richtung und die Y-Achsen-Richtung senkrecht zueinander verlaufen.

3. Layout-Muster der Halbleiterstruktur nach einem der Ansprüche 1 oder 2, wobei jede SOT-Schicht (30), in einer Draufsicht betrachtet, eine elliptische Form präsentiert und wobei insbesondere die zwei in jeder SOT-Schicht (30) enthaltenen Kontaktsteckerstrukturen (16; 18) entlang einer Längsachse der elliptischen Form angeordnet sind.

4. Layout-Muster der Halbleiterstruktur nach einem der Ansprüche 1 bis 3, wobei jede der Dummy-MTJ-Strukturen (40), in einer Draufsicht betrachtet, eine kreisrunde oder quadratische Form aufweist.

5. Layout-Muster der Halbleiterstruktur nach einem der Ansprüche 1 bis 4, wobei eine Dummy-SOT-Schicht (30D) unter jeder Dummy-MTJ-Struktur (40) verbunden ist, aber die Kontaktsteckerstruktur (16; 18) nicht unter jeder Dummy-SOT-Schicht (30D) verbunden ist.

6. Layout-Muster der Halbleiterstruktur nach einem der Ansprüche 1 bis 5, wobei eine Höhe der Dummy-MTJ-Struktur (40), in einem Querschnitt betrachtet, kleiner ist als eine Höhe jeder MTJ-Struktur (20).

7. Verfahren zum Bilden eines Layout-Musters einer Halbleiterstruktur, umfassend:
Bilden mehrerer Spin-Orbit-Torque (SOT)-Schichten, die in einem Array angeordnet sind und sich auf einer dielektrischen Schicht (26) befinden, wobei zwei Kontaktsteckerstrukturen (16; 18) unter jeder SOT-Schicht (30) verbunden sind;
Bilden mehrerer Magnettunnelübergangs (MTJ)-Strukturen, die in einem Array angeordnet sind,
wobei jede MTJ-Struktur (20) sich auf jeder SOT-Schicht (30) befindet und jede SOT-Schicht (30) eine darauf angeordnete MTJ-Struktur (20) umfasst;
**gekennzeichnet durch**
Bilden mehrerer Dummy-MTJ-Strukturen (40) zwischen den Dummy-MTJ-Strukturen (40), wobei sich die Form jeder Dummy-MTJ-Struktur (40) von der Form jeder MTJ-Struktur (20) unterscheidet.

8. Verfahren zum Bilden eines Layout-Musters einer Halbleiterstruktur nach Anspruch 7, wobei jede der MTJ-Strukturen (20) in mehreren Spalten entlang einer Y-Achsen-Richtung angeordnet ist und die mehreren Dummy-MTJ-Strukturen (40) sich in Lücken zwischen den aus den MTJ-Strukturen (20) bestehenden Spalten befinden, wobei insbesondere jede Dummy-MTJ-Struktur (40) sich zwischen vier benachbarten MTJ-Strukturen (20) befindet und die Distanzen von der Dummy-MTJ-Struktur (40) zu den vier benachbarten MTJ-Strukturen (20) gleich sind und/oder jede der MTJ-Strukturen (20), in einer Draufsicht betrachtet, eine rechteckige Form hat und eine Längsseite der rechteckigen Form parallel zu einer X-Achsen-Richtung verläuft, wobei die X-Achsen-Richtung und die Y-Achsen-Richtung senkrecht zueinander verlaufen.

9. Verfahren zum Bilden eines Layout-Musters einer Halbleiterstruktur nach einem der Ansprüche 7 oder 8, wobei jede SOT-Schicht (30), in einer Draufsicht betrachtet, eine elliptische Form präsentiert, wobei insbesondere die zwei in jeder SOT-Schicht (30) enthaltenen Kontaktsteckerstrukturen (16; 18) entlang einer Längsachse der elliptischen Form angeordnet sind.

10. Verfahren zum Bilden eines Layout-Musters einer Halbleiterstruktur nach einem der Ansprüche 7 bis 9, wobei jede der Dummy-MTJ-Strukturen (40), in einer Draufsicht betrachtet, eine kreisrunde oder quadratische Form aufweist.

11. Verfahren zum Bilden eines Layout-Musters einer Halbleiterstruktur nach einem der Ansprüche 7 bis 10, wobei eine Dummy-SOT-Schicht (30D) unter jeder Dummy-MTJ-Struktur (40) verbunden ist, aber die Kontaktsteckerstruktur (16; 18) nicht unter jeder Dummy-SOT-Schicht (30D) verbunden ist.

12. Verfahren zum Bilden eines Layout-Musters der Halbleiterstruktur nach einem der Ansprüche 7 bis 11, wobei eine Höhe der Dummy-MTJ-Struktur (40), in einer Schnittansicht betrachtet, kleiner ist als eine Höhe jeder der MTJ-Strukturen (20).

13. Verfahren zum Bilden eines Layout-Musters einer Halbleiterstruktur nach einem der Ansprüche 7 bis 12, des Weiteren umfassend:
Bilden einer SOT-Materialschicht unter den mehreren MTJ-Strukturen (20) und den mehreren Dummy-MTJ-Strukturen (40);
Stapeln einer mehrschichtigen Photoresistschicht auf die SOT-Materialschicht, die mehreren MTJ-Strukturen (20) und die mehreren Dummy-MTJ-Strukturen (40);
Durchführen eines Ätzschrittes zum Ätzen eines Teils der mehrschichtigen Photoresistschicht und eines Teils der SOT-Materialschicht, um die SOT-Materialschicht in mehreren SOT-Schichten (30) zu unterteilen.

14. Verfahren zum Bilden eines Layout-Musters einer Halbleiterstruktur nach einem der Ansprüche 7 bis 13, des Weiteren umfassend das Bilden einer unteren Elektrodenschicht (19), wobei die SOT-Schicht (30) sich zwischen der unteren Elektrodenschicht und der MTJ-Struktur (20) befindet und die untere Elektrodenschicht und die SOT-Schicht (30) verschiedene Materialien enthalten.

## Revendications

1. Motif d'implantation d'une structure semi-conductrice, comprenant :
une pluralité de couches à couple spin-orbite (SOT) (30) agencées en réseau et situées sur une couche diélectrique (26), dans lequel deux structures de fiche de contact (16 ; 18) sont reliées sous chaque couche SOT (30) ;
une pluralité de structures à jonction tunnel magnétique (MTJ) (20) sont agencées en réseau, et
chaque structure MTJ (20) est située sur chaque couche SOT (30), dans lequel chaque couche SOT (30) comprend une structure MTJ (20) disposée sur celle-ci ;
**caractérisé par**
une pluralité de structures MTJ factices (40) situées entre la pluralité de structures MTJ (20), dans lequel la forme de chaque structure MTJ factice (40) est différente de la forme de chaque structure MTJ (20).

2. Motif d'implantation de la structure semi-conductrice selon la revendication 1, dans lequel chacune des structures MTJ (20) est agencée en une pluralité de colonnes le long d'une direction d'axe Y, et les structures MTJ factices (40) sont situées dans les espaces entre les colonnes composées des structures MTJ (20), en particulier dans lequel chaque structure MTJ factice (40) est située entre quatre structures MTJ adjacentes (20), et les distances entre la structure MTJ factice (40) et les quatre structures MTJ adjacentes (20) sont égales et/ou chacune des structures MTJ (20) présente une forme rectangulaire vue de dessus, et un grand côté de la forme rectangulaire est parallèle à une direction d'axe X, dans lequel la direction d'axe X et la direction d'axe Y sont perpendiculaires l'une à l'autre.

3. Motif d'implantation de la structure semi-conductrice selon l'une quelconque des revendications 1 ou 2, dans lequel chaque couche SOT (30) présente une forme elliptique vue de dessus, et en particulier dans lequel les deux structures de fiche de contact (16 ; 18) incluses dans chaque couche SOT (30) sont agencées le long d'un axe longitudinal de la forme elliptique.

4. Motif d'implantation de la structure semi-conductrice selon l'une quelconque des revendications 1 à 3, dans lequel chacune des structures MTJ factices (40) présente une forme circulaire ou une forme carrée vue de dessus.

5. Motif d'implantation de la structure semi-conductrice selon l'une quelconque des revendications 1 à 4, dans lequel une couche SOT fictive (30D) est connectée sous chaque structure MTJ fictive (40), mais la structure de fiche de contact (16 ; 18) n'est pas connectée sous chaque couche SOT fictive (30D).

6. Motif d'implantation de la structure semi-conductrice selon l'une quelconque des revendications 1 à 5, dans lequel une hauteur de la structure MTJ factice (40) est inférieure à une hauteur de chaque structure MTJ (20) vue en coupe transversale.

7. Procédé de formation d'un motif d'implantation d'une structure semi-conductrice, comprenant :
la formation d'une pluralité de couches à couple spin-orbite (SOT), agencées en réseau et situées sur une couche diélectrique (26), dans lequel deux structures de fiche de contact (16 ; 18) sont connectées sous chaque couche SOT (30) ;
la formation d'une pluralité de structures de jonction tunnel magnétique (MTJ) agencées en réseau,
dans lequel chaque structure MTJ (20) est située sur chaque couche SOT (30), et chaque couche SOT (30) comprend une structure MTJ (20) disposée sur celle-ci ;
**caractérisé par**
la formation d'une pluralité de structures MTJ factices (40) entre les structures MTJ factices (40), dans lequel la forme de chaque structure MTJ factice (40) est différente de la forme de chaque structure MTJ (20).

8. Procédé de formation d'un motif d'implantation d'une structure semi-conductrice selon la revendication 7, dans lequel chacune des structures MTJ (20) est agencée en une pluralité de colonnes le long d'une direction d'axe Y, et la pluralité de structures MTJ factices (40) est située dans des espaces entre les colonnes composées des structures MTJ (20), en particulier dans lequel chaque structure MTJ factice (40) est située entre quatre structures MTJ adjacentes (20), et les distances entre la structure MTJ factice (40) et les quatre structures MTJ adjacentes (20) sont égales et/ou chacune des structures MTJ (20) présente une forme rectangulaire vue de dessus, et un grand côté de la forme rectangulaire est parallèle à une direction d'axe X, dans lequel la direction d'axe X et la direction d'axe Y sont perpendiculaires l'une à l'autre.

9. Procédé de formation d'un motif d'implantation d'une structure semi-conductrice selon l'une quelconque des revendications 7 ou 8, dans lequel chaque couche SOT (30) présente une forme elliptique vue de dessus, en particulier dans lequel les deux structures de fiche de contact (16 ; 18) incluses dans chaque couche SOT (30) sont agencées le long d'un axe longitudinal de la forme elliptique.

10. Procédé de formation d'un motif d'implantation d'une structure semi-conductrice selon l'une quelconque des revendications 7 à 9, dans lequel chacune des structures MTJ factices (40) présente une forme circulaire ou une forme carrée vue de dessus.

11. Procédé de formation d'un motif d'implantation d'une structure semi-conductrice selon l'une quelconque des revendications 7 à 10, dans lequel une couche SOT fictive (30D) est connectée sous chaque structure MTJ fictive (40), mais la structure de fiche de contact (16 ; 18) n'est pas connectée sous chaque couche SOT fictive (30D).

12. Procédé de formation d'un motif d'implantation d'une structure semi-conductrice selon l'une quelconque des revendications 7 à 11, dans lequel une hauteur de la structure MTJ factice (40) est inférieure à une hauteur de chacune des structures MTJ (20) vue en coupe transversale.

13. Procédé de formation d'un motif d'implantation d'une structure semi-conductrice selon l'une quelconque des revendications 7 à 12, comprenant en outre :
la formation d'une couche de matériau SOT sous la pluralité de structures MTJ (20) et la pluralité de structures MTJ factices (40) ;
l'empilement d'une couche de photorésine multicouche sur la couche de matériau SOT, la pluralité de structures MTJ (20) et la pluralité de structures MTJ factices (40) ;
la réalisation d'une étape de gravure pour graver une partie de la couche de photorésine multicouche et une partie de la couche de matériau SOT pour diviser la couche de matériau SOT en la pluralité de couches SOT (30).

14. Procédé de formation d'un motif d'implantation d'une structure semi-conductrice selon l'une quelconque des revendications 7 à 13, comprenant en outre la formation d'une couche d'électrode inférieure (19), dans lequel la couche SOT (30) est située entre la couche d'électrode inférieure et la structure MTJ (20), et la couche d'électrode inférieure et la couche SOT (30) contiennent des matériaux différents.
